# EUROPEAN PATENT APPLICATION

(11) **EP 4 503 146 A1**
(43) Date of publication of application: **05.02.2025**
(21) Application number: 23856083.3
(22) Date of filing: 12.04.2023
(51) Int. Cl.: H01L 31/18

(54) **PHOTOVOLTAIC CELL STRING MANUFACTURING APPARATUS**

(30) Priority: 22.08.2022 CN 202211005998
(71) Applicant: Suzhou Maizhan Automation Technology Co., Ltd., Suzhou, Jiangsu 215200 (CN)
(72) Inventor: ZHOU, Jian, Suzhou, Jiangsu 215200 (CN); LU, Longlong, Suzhou, Jiangsu 215200 (CN); TAO, Yi, Suzhou, Jiangsu 215200 (CN)
(74) Representative: Balder IP Law, S.L.
(86) International application number: PCT/CN2023/087901
(87) International publication number: WO 2024/040988

(57) **Abstract**

The present invention discloses a manufacturing apparatus for a photovoltaic cell string, the manufacturing apparatus including a feeding mechanism, a ribbon feeding mechanism, a jig loading and unloading mechanism, a soldering mechanism, a coating and curing mechanism, and a cell string conveying mechanism. By means of a traction mechanism and a manipulator, multiple strands of ribbons cut to a length required by a process and two kinds of materials of a cell piece are sequentially arranged in sequence, so that the front and back sides of adjacent batteries are pre-soldered into a cell string by multiple strands of ribbons in sequence; and coating adhesion points on the front and back sides of the cell string in the subsequent work flow and curing completely eliminate the risk of poor lapping, eliminating the composite film and PAD points on the front and back sides of the cell piece.

## Description

### TECHNICAL FIELD

The present invention relates to the technical field of solar photovoltaic apparatus manufacturing, and more particularly to a manufacturing apparatus for a solar photovoltaic high-speed coating adhesive cell string.

### BACKGROUND

In the field of solar photovoltaic apparatus manufacturing at home and abroad, there is a solar photovoltaic stringer apparatus in the prior art; in the manufacturing process of a cell string, a busbar of a cell piece and a metal wire are soldered via a silver paste, and the alignment degree of the position between the metal wire and the busbar of the cell piece is required to be high; the busbar of the metal wire cell piece is connected and soldered with a small contact area, and the soldering performance is general. In addition, silver paste soldering has a greater impact on the light transmission;

In addition, with nonbusbar soldering technique, after a single cell string unit is made by means of a transparent composite film and a metal wire, the connection is performed with a cell product, and in the subsequent manufacturing process of a photovoltaic module, a low-melting-point alloy on the surface of the metal wire is connected with the grid line through lamination; the prior art manufacturing cost of the single cell string unit is relatively high, the temperature resistance and light transmission of the internal composite film are poor, and multiple strands of metal wires are unstable in contact with a silver paste, thus reducing the electrical conductivity.

### SUMMARY

### 1. Technical problem to be solved by the present invention

The problems of higher requirements for soldering accuracy and higher cost of silver paste in the existing traditional stringing technology, and the defects of using a composite film in the nonbusbar soldering technology, which result in relatively serious optical shielding and higher cost of the composite film, are not conducive to the technical promotion and progress, and the soldering among cell pieces is easy to lead to the problems of decreased light transmittance, decreased electrical conductivity and insufficient soldering strength, the present invention provides a manufacturing apparatus for a cell string; by designing the structure of the ribbon for connecting the cell pieces in series and the device for connecting the ribbon, problems such as a decrease in light transmittance and a decrease in electrical conductivity of the cell pieces can be effectively solved.

### 2. Technical solution

In order to achieve the above-mentioned objective, the technical solution provided by the present invention is a manufacturing apparatus for a photovoltaic cell string including a feeding mechanism including a material box transport track, a material box lifting mechanism, a cell piece feeding mechanism, a cell piece transport track, and a cell piece loading mechanism; a ribbon feeding mechanism including an unwinding mechanism, a cutting mechanism, and a traction mechanism; a jig loading and unloading mechanism including a jig loading mechanism and a jig unloading mechanism; a soldering mechanism for soldering the ribbons and the cell piece to form a cell string; a coating and curing mechanism including a front coating and curing mechanism, a cell string turnover mechanism and a back coating and curing mechanism; and
a cell string conveying mechanism including a belt conveying structure.

As a further improvement of the present invention, the material box transport track is driven by a belt, a cell piece material box is placed thereon, a plurality of cell pieces are stacked inside the cell piece material box, and one end of the material box transport track is connected to the material box lifting mechanism.

As a further improvement of the present invention, a lifting platform is provided on the material box lifting mechanism, a transmission belt is provided on the lifting platform, the transmission belt is aligned with the material box transport track, and the cell piece material box moves from the material box transport track to the lifting platform.

As a further improvement of the present invention, a grabbing board is connected to the output end of the cell piece feeding mechanism, a suction nozzle is mounted at two ends of the grabbing board, and the grabbing board is located above and is always parallel to the lifting platform, the suction nozzle grabs the cell piece and places same at one end of a cell piece transport track, and a CCD locating platform is provided at the other end of the cell piece transport track.

As a further improvement of the present invention, the manufacturing apparatus further includes a manipulator, and the manipulator is mounted at a position where the CCD locating platform is located, and the cell piece loading mechanism is a manipulator suction cup module on the manipulator, and the manipulator suction cup module is used for grabbing and placing the cell piece.

As a further improvement of the present invention, the manufacturing apparatus further includes a manipulator, and the manipulator is mounted at a position where the CCD locating platform is located, the jig loading mechanism includes a manipulator magnetic module on the manipulator, the manipulator magnet module (105b) is used for grabbing and placing the main jig, and the jig unloading mechanism includes a main jig unloading mechanism.

As a further improvement of the present invention, the jig loading mechanism further includes a auxiliary jig loading mechanism, and the jig unloading mechanism further includes a auxiliary jig unloading mechanism.

As a further improvement of the present invention, the jig loading and unloading mechanism further includes a jig locating mechanism and a jig return track, and the auxiliary jig unloading mechanism and the main jig unloading mechanism grab and place the auxiliary jig and the main jig on the jig return track to return.

As a further improvement of the present invention, the ribbon feeding mechanism further includes a soldering flux pool, the unwinding mechanism is provided with a ribbon, and the ribbon is a composite metal wire, the soldering flux pool is located at one end of the unwinding mechanism, the traction mechanism pulls the ribbon to successively pass through the soldering flux pool and a cutting mechanism, and the surface of the ribbon is coated with the flux via the soldering flux pool and then cut into multiple strands of ribbons via the cutting mechanism.

As a further improvement of the present invention, the soldering mechanism includes a first heating module that heats the bottom of the cell string and a second heating module that heats an upper surface of the cell string.

As a further improvement of the present invention, the heating means is infrared heating.

As a further improvement of the present invention, the front coating and curing mechanism and the back coating and curing mechanism each include a coating mechanism and a curing mechanism.

As a further improvement of the present invention, the cell string turnover mechanism also includes a heating device that heats the cell string during transportation.

As a further improvement of the present invention, the coating and curing mechanism includes two sets of a cell string turnover mechanism and a back coating and curing mechanism which are provided to match each other.

As a further improvement of the present invention, the cell string turnover mechanism is arranged adjacent to the cell string conveying mechanism, and the cell string turnover mechanism places the coated and cured cell string on the conveying belt of the cell string conveying mechanism, and transmits the manufactured cell string to the next station to complete the cell string manufacturing process.

### 3. Advantageous effects

With the technical solution provided by the present invention, compared with the prior art, the following beneficial effects are obtained: the photovoltaic cell string apparatus of the present invention produces a cell string consisting of at least one trailing cell piece, a leading cell piece, and at least one intermediate cell piece, with a primary back side of the cell piece and a ribbon soldered together during manufacturing to form the cell string. By means of a traction mechanism and a manipulator, multiple strands of ribbons cut to a length required by a process and two kinds of materials of a cell piece are sequentially arranged in sequence, so that the front and back sides of connected batteries are pre-soldered into a cell string by multiple strands of ribbons in sequence; adhesive application and curing of the adhesive in subsequent workflows eliminates the risk of poor overlap. This method reduces the alignment requirement between the ribbon and the finger of the cell piece, which is beneficial to simplify the manufacturing process of the cell string. At the same time, the PAD points on the front and back sides of the composite film and the cell piece are eliminated, the shielding on the surface of the photovoltaic cell piece is reduced, the use of silver paste is reduced, the cost is greatly reduced, and the bonding force between the ribbon and the cell piece is improved by applying adhesive on both sides and curing. Further, the cell string turnover mechanism further includes a heating device, which maintains a temperature during the cell string transportation process, so that the thermal stress of the ribbon can be slowly released and a certain temperature can be ensured, and it can ensure that the temperature difference between the soldering process and the turnover station is not too large, and ensure that a large stress is released after coating, thereby improving the stability of the electrical performance of the cell string. Further, the manufacturing apparatus for a photovoltaic cell string includes two sets of a cell string turnover mechanism and a back coating and curing mechanism, which can achieve the effect of quickly coating and curing an adhesion point on the back of the cell string, thereby improving productivity.

### BRIEF DESCRIPTION OF DRAWINGS

FIG. 1 is an overall schematic structural diagram showing an overall manufacturing apparatus for a photovoltaic cell string.
FIG. 2 is a schematic structural perspective view showing a material box transport track.
FIG. 3 is a schematic structural perspective view showing a material box lifting mechanism.
FIG. 4 is a schematic structural perspective view showing a cell piece feeding mechanism.

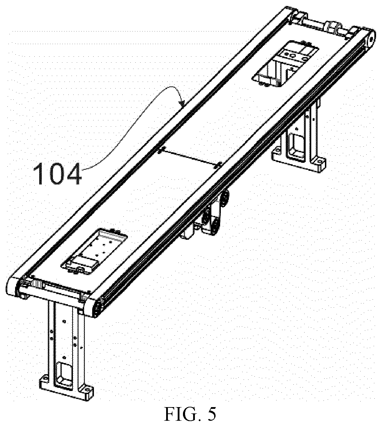

FIG. 5 is a schematic structural perspective view showing a cell piece transport track.

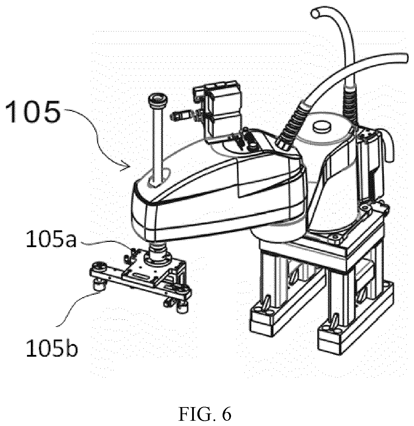

FIG. 6 is a schematic structural perspective view showing a manipulator.

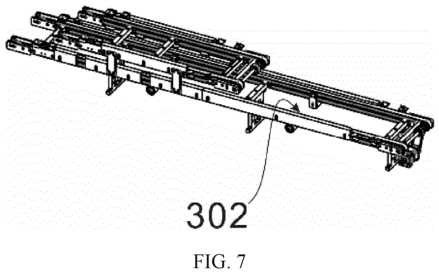

FIG. 7 is a schematic structural perspective view showing a jig return track.

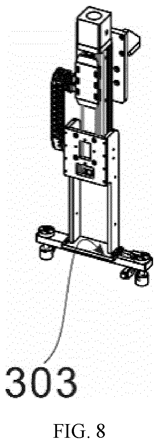

FIG. 8 is a schematic structural perspective view showing a main jig unloading mechanism.

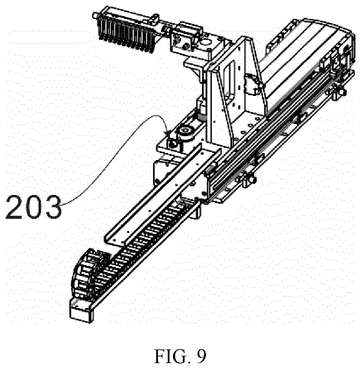

FIG. 9 is a schematic structural perspective view showing a traction mechanism.

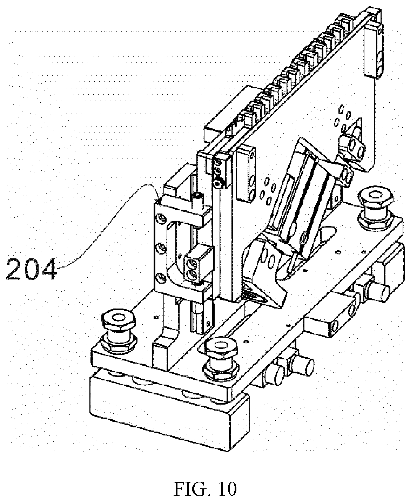

FIG. 10 is a schematic structural perspective view showing a cutting mechanism.

### Introduction to reference numerals:

100. feeding mechanism; 101. material box transport track; 102. material box lifting mechanism; 103. cell piece feeding mechanism; 104. cell piece transport track; 105. manipulator; 101a. cell piece material box; 102a. lifting platform; 103a. grabbing board; 103a-1. suction nozzle; 104a. locating platform; 105a. manipulator suction cup module; 105b. manipulator magnetic module;
200. ribbon feeding mechanism; 201. unwinding mechanism; 202. soldering flux pool; 203. traction mechanism; 204. cutting mechanism;
300. jig loading and unloading mechanism; 301. jig locating mechanism; 302. jig return track; 303. main jig unloading mechanism; 304. auxiliary jig loading mechanism; 305. auxiliary jig unloading mechanism;
400. soldering mechanism;
500. coating and curing mechanism; 501. front coating and curing mechanism; 502. cell string turnover mechanism; 503. back coating and curing mechanism;
600. cell string conveying mechanism.

### DETAILED DESCRIPTION OF THE EMBODIMENTS

For a further understanding of the present invention, reference is made to the accompanying drawings and examples.

The structures, proportions, dimensions, etc. shown in the drawings and described herein are merely for the purpose of teaching a person skilled in the art to which the present invention pertains and are not intended to limit the scope of the present invention. Thus, it is intended that the present invention not be limited to the particular embodiments disclosed herein, but that the present invention may be practiced without departing from the spirit and scope of the present invention as set forth in the appended claims. At the same time, the terms "upper", "lower", "left", "right", "middle" and the like in the description are merely used for convenience of description and are not intended to limit the scope of the present invention, and changes or modifications in the relative relationships thereof may be made without materially changing the technical contents to be regarded as the scope of the present invention.

### Embodiment 1

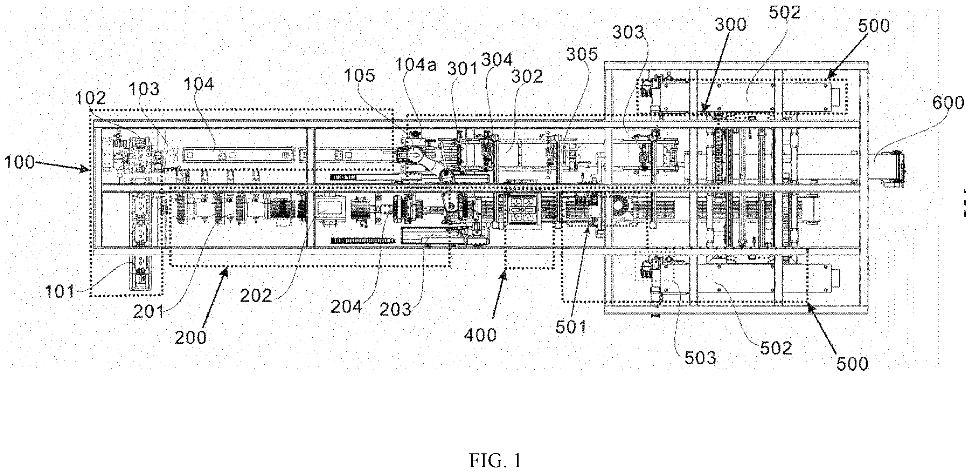

A first embodiment of the present invention provides a manufacturing apparatus for a photovoltaic cell string. Referring to FIG. 1, the overall apparatus diagram includes a feeding mechanism 100 which is mounted on one side of a rack and includes a material box transport track 101, a material box lifting mechanism 102, a cell piece loading mechanism 103, a cell piece transport track 104 and a manipulator suction cup module 105a, where the manipulator suction cup module 105a can grab and place the cell piece;
a ribbon feeding mechanism 200 including an unwinding mechanism 201, a cutting mechanism 204, and a traction mechanism 203;
a jig loading and unloading mechanism 300 including a jig loading mechanism, a jig unloading mechanism, a jig locating mechanism 301 and a jig return track 302;
a soldering mechanism 400 including a first heating module that heats the bottom of the cell string and a second heating module that heats an upper surface of the cell string;
a coating and curing mechanism 500 including a front coating and curing mechanism 501, a cell string turnover mechanism 502 and a back coating and curing mechanism 503; and
a cell string conveying mechanism 600 including a belt conveying structure.

The feeding mechanism 100 is parallel to the soldering mechanism 400, and the manipulator 105 is located at the middle position of the whole machine frame to facilitate the manipulator suction cup module 105a and the manipulator magnetic module 105b to grab and place the cell piece and the main jig.

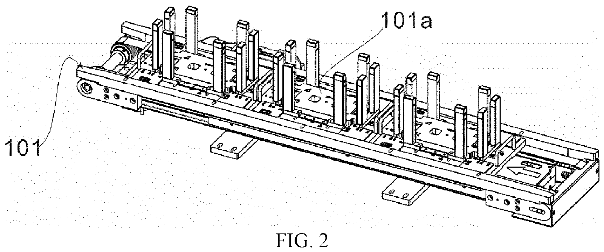

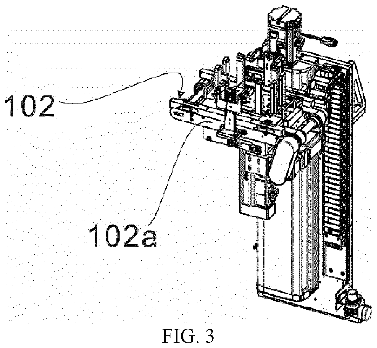

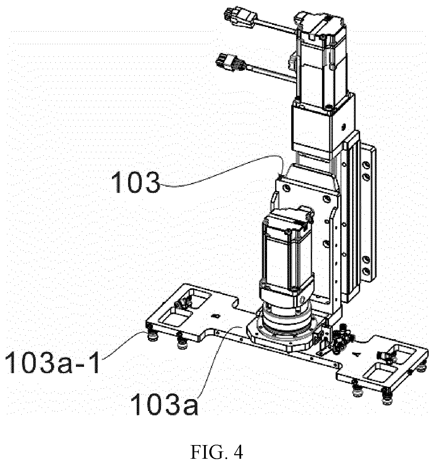

Specifically, referring to FIGS. 1 and 2, in the feeding mechanism 100, a material box transport track 101 is driven by a belt, a cell piece material box 101a is placed on the material box transport track, a plurality of cell pieces are stacked in the cell piece material box 101a, one end of the material box transport track 101 is connected to the material box lifting mechanism 102; referring to FIG. 3, the material box lifting mechanism 102 is provided with a lifting platform 102a which is provided with a transmission belt, the transmission belt is aligned with the material box transport track 101, and the cell piece material box is transferred from the material box transport track 101 to the lifting platform 102a. Referring to FIG. 4, a grabbing board 103a is connected to the output end of the cell piece feeding mechanism 103, a suction nozzle 103a-1 is mounted at two ends of the grabbing board 103a which is located above the lifting platform 102a and is always parallel to the lifting platform 102a, the suction nozzle 103a-1 grabs the cell piece in the cell piece material box 101a and places the cell piece at one end of a cell piece transport track 104, a CCD locating platform 104a is provided at the other end of the cell piece transport track 104, and a manipulator 105 is mounted at a position where the CCD locating platform is located. When the apparatus is working, the cell pieces are stacked and placed in a premanufactured material box for loading and conveying at the same time; the cell pieces are respectively placed on a conveying belt for conveying by lifting, slicing and grabbing the material box; the cell pieces are detected by CCD and are to be determined on the locating platform. When all the cell pieces in the cell piece material box 101a are picked up by the cell piece feeding mechanism 103, the material box lifting mechanism 102 descends to carry the cell piece material box 101a to the material box return track located below the material box transport track 101 to return. In addition, the cell piece loading mechanism is a manipulator suction cup module 105a of the machine 105, and the manipulator suction cup module 105a is used for grabbing the cell piece and placing same on the cell string processing platform station.

Further, the ribbon feeding mechanism 200 includes an unwinding mechanism 201, a soldering flux pool 202, a cutting mechanism 204, and a traction mechanism 203. The unwinding mechanism 201 is provided with a ribbon, where the ribbon is a composite metal wire; a soldering flux pool 202 is located at one end of the unwinding mechanism; a traction mechanism 203 pulls the ribbon to successively pass through the soldering flux pool 202 and the cutting mechanism 204; the surface of the ribbon passes through the soldering flux pool 202 and is coated with a flux with a thickness of micron; and then the ribbon with the flux is cut into multiple strands through the cutting mechanism 204. In operation, the multiple strands of ribbons is cut into head and tail last multiple strands of ribbons and a middle multiple strands of ribbons of a length required by the process through the unwinding mechanism 201, the soldering flux pool, the cutting mechanism 204 and the traction mechanism 203, and is placed at the station of the cell string processing platform station. Where the length of the head and tail multiple strands of ribbons exceeds the cell piece by a distance to facilitate the external electrical lead-out of the cell string. The middle multiple strands of ribbons, where the length between any adjacent cell pieces on the middle multiple strands of ribbons is cut into what is suitable for middle multiple strands of ribbons arranged equally via a cutting mechanism, and the middle multiple strands of ribbons electrically connect the adjacent cell pieces.

Further, the jig loading and unloading mechanism includes a jig loading mechanism, a jig unloading mechanism, a jig locating mechanism 301, and a jig return track 302. The jig loading mechanism includes a manipulator magnetic module 105a on a manipulator 105, the manipulator magnet module 105b serves as a main jig loading mechanism for grabbing and placing a main jig, and the jig unloading mechanism includes a main jig unloading mechanism 303. In operation, the manipulator magnetic module 105b grabs the main jig and cooperates with the ribbon feeding mechanism to complete the arrangement of the ribbon, the cell piece and the main jig. The jig locating mechanism 301 is provided at one end of the jig return track 302, the main jig unloading mechanism 303 is located at the other end of the jig return track 302, and the jig locating mechanism 301 is connected to the CCD locating platform 104a.

Alternatively, the jig loading mechanism may further include a auxiliary jig loading mechanism 304, and the jig unloading mechanism may further include a auxiliary jig unloading mechanism 305. The auxiliary jig loading mechanism 304 grabs the auxiliary jig and places it on the cell piece to ensure a tight attachment between the ribbon and the cell piece during soldering and coating.

Specifically, as shown in FIG. 1, a plurality of strands of ribbons cut to a length required for the process are placed on a cell string processing platform station by a traction mechanism, and a cell piece is grabbed by a manipulator suction cup module 105a and placed, and the steps of cutting and placing the ribbons and placing the cell piece are repeated to form a cell string laminated on the cell string processing platform station. Specifically, firstly, a ribbon cut to a desired length is moved to a working position via a traction mechanism; a cell piece is grabbed and placed on the ribbon via a manipulator suction cup module 105a, and is moved to the next working position; an intermediate multiple strands of ribbons is cut to form via an unwinding mechanism 201, a soldering flux pool 202, a cutting mechanism 204 and a traction mechanism 203 to be placed on the upper surface of the cell piece via the traction mechanism, where the intermediate multiple strands of ribbons includes a front end portion and a rear end portion, and the front end portion of the ribbon is located on the upper surface of the cell; the manipulator suction cup module 105a grabs the cell piece and places it on the rear section portion of the multiple strands of ribbons so that the rear end portion of the ribbon is in close contact with the back surface of the cell piece, while the manipulator magnetic module 105b grabs the main jig and places it on the surface of the cell piece on which the front end portion of the ribbon has been laminated so that the front end portion of the ribbon on the surface of the cell piece is tightly attached to the cell piece. The cell string conveying belt moves to the next work station, the auxiliary jig loading mechanism grabs and places the auxiliary jig at the two side positions of the cell main jig, so that the upper and lower multiple strands of ribbons of the cell piece are tightly attached to the cell piece, and the cell string conveying belt moves to the soldering work station.

In this embodiment, the cell string soldering platform includes a soldering mechanism 400 including a first heating module that heats the bottom of the cell string and a second heating module that heats the upper surface of the cell string. The heating module can use an infrared tube to heat, so that the upper and lower multiple strands of ribbons are soldered to the front and back sides of the cell piece to form a cell string. The temperature of all heating elements can be fed back using thermocouples, pyrometers, etc. and the trend of measurement data can be displayed on HMI to ensure the stability of soldering temperature. It may also be soldered by other means such as microwave heating or laser heating.

After using the soldering process for treatment, a coating and curing process is performed by the coating and curing mechanism 500 to coat adhesion points on the designated positions of the cell string. The designated position can be either on the finger line or between the two sides of the finger line, the adhesion point after curing can achieve the purpose of binding the ribbons, and the process of coating the adhesion points at the designated position can alternatively use a camera for auxiliary positioning to ensure that the adhesion point position can form a better connection with the ribbon.

The coating and curing mechanism 500 includes a front coating and curing mechanism 501, a cell string turnover mechanism 502 and a back coating and curing mechanism 503. In the front coating process of the cell string, the ribbon and the cell piece treated by the soldering process have formed a solder, so that the primary-auxiliary jig can be removed to perform the coating operation.

Preferably, the ribbon jig coating may be applied in consideration of the operational stability, ensuring that the tail and head of the ribbon is closely adhered to the surface of the cell piece, ensuring that the ribbon and the cell piece are always in a bound state before the coating adhesion point is fixed, and ensuring that the operation of the coating mechanism is not interfered. When applying the ribbon jig coating, one of the main jig and the auxiliary jig can be ensured to be attached to the cell piece for applying, or at least one of the main jig and the auxiliary jig is hollowed out so as to apply the ribbon jig coating at the hollowed-out position of the jig, or a combination of the above two methods, i.e., ensuring that at least one jig is attached to the cell piece during the coating process. After the front coating and curing operation is completed on the entire front side of the cell string, the cell string is turned over by the cell string turnover mechanism 502, and the turnover cell string is located below the back side coating and curing mechanism 503, and the back side coating and curing mechanism 503 coats and cures the adhesion points on the back side of the cell string.

Alternatively, the cell string turnover mechanism 503 further includes a heating device which is able to maintain the cell string during transportation within a certain temperature range, so that the thermal stress of the metal can be released slowly and at a certain temperature, which is in the range of 40°C-140°C, it can be ensured that the temperature difference between the soldering process and the turnover station is not too great, ensuring that the greater stress is released after the adhesion point is cured. It should be noted that the ribbon and the finger form a stable connection after soldering, and the bonding force is greater than the bonding force between the finger and the cell piece.

Alternatively, the coating and curing mechanism 500 includes two sets of the cell string turnover mechanism 502 and the back coating and curing mechanism 503, and as described referring to FIG. 1, the cell string turnover mechanism 502 and the back coating and curing mechanism 503 are cooperatively arranged on two sides of the cell string conveying mechanism 600, which may also be located on one side of the cell string conveying mechanism 600. The above-described embodiment can achieve the effect of rapidly coating the back surface of the cell string with adhesion points and curing to improve the productivity.

In addition, the cell string turnover mechanism 503 is arranged adjacent to the cell string conveying mechanism 600, and after a curing process is performed on the adhesion point on the back surface of the cell string, the cell string is placed on a conveying belt of the cell string conveying mechanism 600 by means of the cell string turnover mechanism 503, and the manufactured cell string is conveyed to the next station to complete the cell string manufacturing process.

The present invention and its embodiments have been described above schematically, without limitation, and the drawings show only one embodiment of the present invention and the actual structure is not limited thereto. Therefore, it is within the scope of the present invention for a person skilled in the art to be inspired to design a structural mode and an embodiment similar to the technical solution without involving any inventiveness.

## Claims

1. A manufacturing apparatus for a photovoltaic cell string, comprising
a feeding mechanism (100) comprising a material box transport track (101), a material box lifting mechanism (102), a cell piece feeding mechanism (103), a cell piece transport track (104), and a cell piece loading mechanism;
a ribbon feeding mechanism (200) comprising an unwinding mechanism (201), a cutting mechanism (204), and a traction mechanism (203);
a jig loading and unloading mechanism (300) comprising a jig loading mechanism and a jig unloading mechanism;
a soldering mechanism (205) for soldering ribbons and the cell pieces to form a cell string;
a coating and curing mechanism (500) comprising a front coating and curing mechanism (501), a cell string turnover mechanism (502) and a back coating and curing mechanism (503); and
a cell string conveying mechanism (600) comprising a belt conveying structure.

2. The manufacturing apparatus for a photovoltaic cell string according to claim 1, wherein the material box transport track (101) is driven by a belt, a cell piece material box (101a) is placed thereon, a plurality of cell pieces are stacked inside the cell piece material box (101a), and one end of the material box transport track (101) is connected to the material box lifting mechanism (103).

3. The manufacturing apparatus for a photovoltaic cell string according to claim 2, wherein a lifting platform (102a) is provided on the material box lifting mechanism (102), a transmission belt is provided on the lifting platform (102a), the transmission belt is aligned with the material box transport track (101), and the cell piece material box moves from the material box transport track (101) to the lifting platform (102a).

4. The manufacturing apparatus for a photovoltaic cell string according to claim 3, wherein a grabbing board (103a) is connected to the output end of the cell piece feeding mechanism (103), a suction nozzle (103a-1) is mounted at two ends of the grabbing board (103a), and the grabbing board (103a) is located above and is always parallel to the lifting platform (103a), the suction nozzle (103a-1) grabs the cell piece and places at one end of a cell piece transport track (104), and a CCD locating platform (104a) is provided at the other end of the cell piece transport track (104).

5. The manufacturing apparatus for a photovoltaic cell string according to claim 1, wherein the manufacturing apparatus further comprises a manipulator (105), and the manipulator (105) is mounted at a position where the CCD locating platform is located, and the cell piece loading mechanism is a manipulator suction cup module (105a) on the manipulator (105), and the manipulator suction cup module (105a) is used for grabbing and placing the cell piece.

6. The manufacturing apparatus for a photovoltaic cell string according to claim 1, wherein the manufacturing apparatus further comprises a manipulator (105), and the manipulator (105) is mounted at a position where the CCD locating platform is located, the jig loading mechanism comprises a manipulator magnetic module (105a) on the manipulator (105), the manipulator magnet module (105b) is used for grabbing and placing the main jig, and the jig unloading mechanism comprises a main jig unloading mechanism (303).

7. The manufacturing apparatus for a photovoltaic cell string according to claim 6, wherein the jig loading mechanism further comprises a auxiliary jig loading mechanism (304), and the jig unloading mechanism further comprises a auxiliary jig unloading mechanism (305).

8. The manufacturing apparatus for a photovoltaic cell string according to claim 7, wherein the jig loading and unloading mechanism (300) further comprises a jig locating mechanism (301) and a jig return track (302), and the auxiliary jig unloading mechanism (305) and the main jig unloading mechanism (303) grab and place the auxiliary jig and the main jig on the jig return track (302) to return.

9. The manufacturing apparatus for a photovoltaic cell string according to claim 1, wherein the ribbon feeding mechanism (200) further comprises a soldering flux pool (202), the unwinding mechanism (201) is provided with a ribbon, and the ribbon is a composite metal wire, the soldering flux pool (202) is located at one end of the unwinding mechanism, the traction mechanism (203) pulls the ribbon to successively pass through the soldering flux pool (202) and a cutting mechanism (204), and the surface of the ribbon is coated with the flux via the soldering flux pool (202) and then cut into multiple strands of ribbons via the cutting mechanism (204).

10. The manufacturing apparatus for a solar photovoltaic high-speed coating adhesive cell string according to claim 1, wherein the soldering mechanism (400) comprises a first heating module that heats the bottom of the cell string and a second heating module that heats an upper surface of the cell string.

11. The manufacturing apparatus for a solar photovoltaic high-speed coating adhesive cell string according to claim 10, wherein the heating means is infrared heating.

12. The manufacturing apparatus for a photovoltaic cell string according to claim 1, wherein the front coating and curing mechanism (501) and the back coating and curing mechanism (503) each comprise a coating mechanism and a curing mechanism.

13. The manufacturing apparatus for a photovoltaic cell string according to claim 1, wherein the cell string turnover mechanism (502) also comprises a heating device that heats the cell string during transportation.

14. The manufacturing apparatus for a photovoltaic cell string according to claim 1, wherein the coating and curing mechanism (500) comprises two sets of a cell string turnover mechanism (502) and a back coating and curing mechanism (503) which are provided to match each other.

15. The manufacturing apparatus for a photovoltaic cell string according to claim 1, wherein the cell string turnover mechanism (502) is arranged adjacent to the cell string conveying mechanism (600), and the cell string turnover mechanism (502) places the coated and cured cell string on the conveying belt of the cell string conveying mechanism (600), and transmits the manufactured cell string to the next station to complete the cell string manufacturing process.
